# EUROPEAN PATENT SPECIFICATION

(11) **EP 0 663 616 B1**
(45) Date of publication and mention of the grant of the patent: **30.10.2002**
(21) Application number: 94309847.5
(22) Date of filing: 28.12.1994
(51) Int. Cl.: G03F 7/039, H05K 3/06, C08L 33/06, C08L 33/20, C08L 25/18

(54) **Radiation sensitive material and method for forming pattern**
Strahlungsempfindliches Material und Verfahren zur Herstellung eines Musters
Matériau sensible au rayonnement et méthode de formation d'un dessin

(30) Priority: 28.12.1993 JP 33743493
(43) Date of publication of application: 19.07.1995
(60) Divisional application: 02008746.6
(73) Proprietor: FUJITSU LIMITED, Kawasaki-shi, Kanagawa 211 (JP)
(72) Inventor: Takechi, Satoshi, c/o Fujitsu Limited, Kawasaki-shi, Kanagawa 211 (JP); Takahashi, Makoto, c/o Fujitsu Limited, Kawasaki-shi, Kanagawa 211 (JP); Kaimoto, Yuko, c/o Fujitsu Limited, Kawasaki-shi, Kanagawa 211 (JP)
(74) Representative: Silverman, Warren

(56) References cited:
- EP-A- 0 487 261
- EP-A- 0 544 465
- DATABASE WPI, AN. 92-094 027 (12), DERWENT PUBLICATIONS LTD., London; & JP-A-04 039 665 (FUJITSU LTD)

## Description

### BACKGROUND OF THE INVENTION

The present invention relates to a radiation sensitive material and a process for forming a pattern using the same.

Recently, semiconductor integrated circuits have become more integrated and LSls and VLSIs are practically available. Accompanying such integration, circuit patterns have become smaller in size, approaching submicron dimensions and even smaller. Formation of a pattern in a submicron dimension essentially requires lithography. In lithography a thin film resist is deposited on to a substrate to be processed, and is selectively exposed and developed to form a resist pattern. With this resist pattern as a mask, dry etching is conducted and then the resist is removed to obtain a required pattern. As an exposure source for lithography, ultraviolet radiation was originally used, but as circuit patterns approach submicron sizes, far ultraviolet radiation (e.g. electron beams, X rays, etc.) with short wavelengths, are used as exposure sources.

Especially for lithography using excimer lasers (248-nm wavelength KrF laser and 193-nm wavelength ArF laser), resist materials having high resolution, high sensitivity and good dry-etching resistance are required.

Many conventionally developed resists are based on phenol resin and novolak resin. These materials have aromatic rings and good dry etching resistance, but they have poor transparency at KrF wavelength and are totally opaque at ArF wavelength. Consequently they can not provide patterns sufficiently precise in submicron dimensions.

On the other hand, as a transparent resist for excimer beams, t-butyl methacrylate polymer is proposed, but this resist lacks dry etching resistance.

As a countermeasure to this, the inventors have proposed , a chemical amplification type resist using alicyclic groups as a resist having dry etching resistance comparable with that of aromatic compounds and are transparent at KrF and ArF wavelength. Here alicyclic groups are adamantane, norbornane, perhydroantracene, cyclohexane, tricyclo [5.2.1.0^{2,6}] decane etc., and adamantyl groups are suitable (see Japanese Patent Laid-Open Publication No. 39665/1992).

But the chemical amplification type resist of alicyclic copolymer increases hydrophobicity and rigidity of the alicyclic group, which gives dry etching resistance, increases its composition ratio.

At a composition ratio which gives dry etching resistance comparable to that of phenol resin-based and novolak resin-based resists, e.g., above 50 mol% of alicyclic unit, because of high hydrophobicity and rigidity of the resists, diffusion of protonic acid as a catalyst is hindered, which results in lower amplification, smaller amounts of carboxylic acid being generated, and lower solubility to a developer of an alkaline aqueous solution.

Furthermore, these resists lack adhesiveness, and, in addition, their resist films are rigid because of inclusion of alicyclic groups. As a rasult, strain caused to the resist films become larger, and the resist films have a greater tendency to peel off. Accordingly stable pattern characteristics cannot be obtained. This is also a problem.

### SUMMARY OF THE INVENTION

In view of these problems, an object of the present invention is to provide a radiation sensitive material for an excimer laser lithography, having good transparency arid etching resistance, is highly sensitive, has good adhesion and to provide a method for forming a circuit pattern using the radiation sensitive material.

Another object of the present invention is to provide a method for forming a pattern which can produce a protective film from even a non-phenol based polymer of low polarity, and which can have stable pattern characteristics.

The above-described object of the present invention is achieved by a radiation sensitive material comprising: a copolymer expressed by a general formula 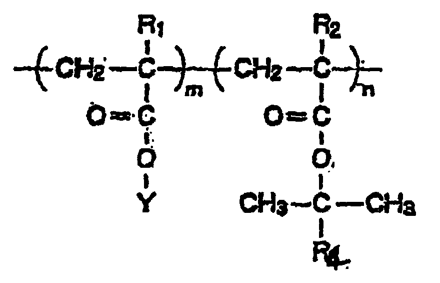 (where Y represents an alicyclic group; R₁ and R₂ represent CH₃ or H, and at least one of R₁ and R₂ is H; and R₄ represents an alkyl group); and a substance generating an acid by application of radiation.

In the above-described radiation sensitive material, it is preferable that the copolymer includes, by 40 - 70 mol%, a unit structure including alicyclic groups.

The above-described object of the present invention is also achieved with a radiation sensitive material comprising a terpolymer expressed by a general formula 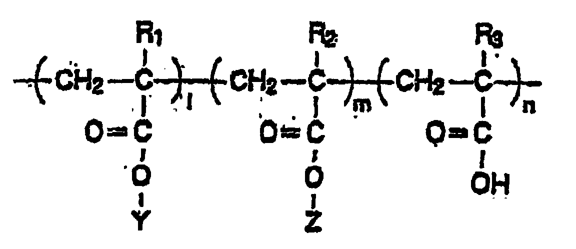 (where Y represents alicyclic group; Z represents -C(CH₃)₂R₄, 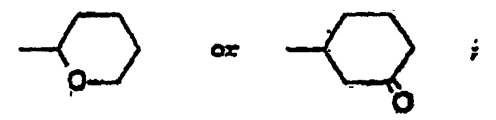 R₁, R₂, and R₃ represent CH₃ or H; and R₄ represents an alkyl group); and a substance generating an acid by application of radiation.

In the above-described radiation sensitive material, it is preferable that the terpolymer includes the unit structure having carboxyl in the range of 5-35 mol%.

The above-described object of the present invention is further achieved with a radiation sensitive material comprising :
a terpolymer expressed by a general formula 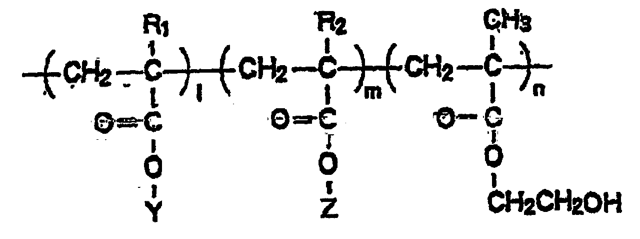 (where Y represents an alicyclic group; and Z represents -C(CH₃)₂R₄, 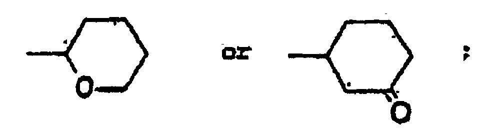
R₁ and R₂ represent CH₃ or H; and R₄ represents an alkyl group); and a substance generating an acid by application of radiation.

In the above-described radiation sensitive material, it is preferable that the terpolymer includes hydroxyethyl methacrylate by above 5 mol%.

The above-described object of the present invention is additionally achieved with a copolymer expressed by a general formula 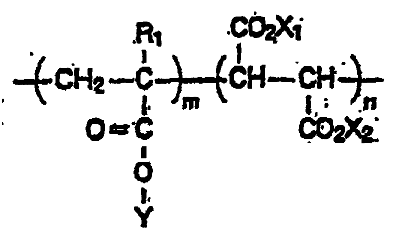 (where X₁ and X₂ represent -C(CH₃)₂R₄, 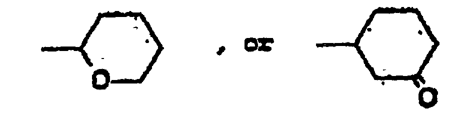 Y represents an alicyclic group; R₁ represent CH₃ or H; and R₄ represents an alkyl group); and a substance genarating an acid by application of radiation.

The above-described object of the present invention is yet further achieved with fourth general embodiment by a radiation sensitive material comprising:
a copolymer including a unit structure expressed by the general formula 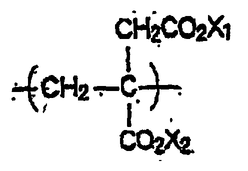 a radiation sensitive material comprising: a copolymer expressed by a general formula 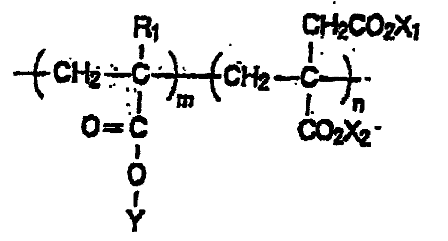 (where X₁ and X₂ represent -C(CH₃)₂R₄, 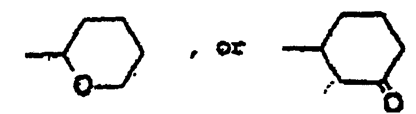
Y represents an alicyclic group; R₁ represents CH₃ or H; and R₄ represents an alkyl group); and a substance generating an acid by application of radiation.

The above-described object of the present invention is even further achieved more generally in a by a radiation sensitive material comprising:
a copolymer including:
a unit structure expressed by the general formula 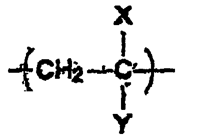 (where at least one of X and Y is a nitrile group) ; and
a unit structure which includes an alicyclic group and
a unit structure which generates an alkali soluble group in the presence of an acid; and
a substance generating, an acid by application of radiation,
wherein the copolymer includes an alicyclic group.

Groups which generate alkali soluble groups in the presence of acid are, an ester group, t-butyl group, tetrahydropyranyl group, α,α-dimethylbenzyl group, 3-oxocyclohexyl group, etc., and groups which are released in the presence of protonic acid can be used. In view of transparency with respect to excimer beams, groups without benzene rings are suitable. Thus, t-butyl group, tetrahydropyranyl group, 3-oxocyclohexyl group are more preferable.

In this last described radiation sensitive material, it is preferable that the unit structure 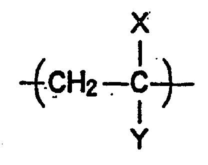 (where at least one of X and Y is nitrile group) is acrylonitrile or methacrylonitrite.

In the above-described radiation sensitive material, it is preferable that the copolymer includes the acrylonitrile or methacrylonitrile by 10-70 mol%.

The invention also provides a method for forming a pattern comprising the steps of: preparing a resist of the above-described radiation sensitive material, applying the resist to a substrate to be processed; prebaking the resist film and then selectively exposing the resist on the substrate to radiation to generate said acid; and post exposure baking and then developing the resist on the substrate to form the pattern. Developing of the resist on the substrate to form the pattern is preferably carried out by a developer which is a mixed liquid of an organic alkaline aqueous solution and isopropyl alcohol to form the pattern, the isopropyl alcohol preferably constituting 5-95% by vol, of the developer.

The radiation sensitive material comprises: a copolymer including a unit structure including alicyclic groups, e.g. adamantyl groups, norbornyl group, and a unit structure generating an alkali soluble group in the presence of an acid, and a substance generating an acid by application of radiation.

A substance generating an acid by application of radiation used in the above-described radiation sensitive material, i.e. an acid generating substance can be provided by:
an s-triazine derivative expressed by the general formula 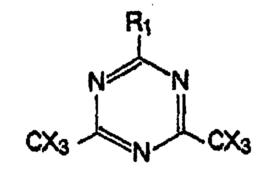 (where R₁ represents a substituted or an unsubstituted aryl group or alkenyl group; and X represents Cl or Br).
an oxazole derivative expressed by the general formula 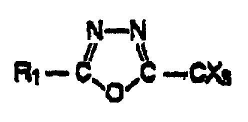 (where R₁ represents CH₃, substituted or an unsubstituted alkyl group, or a substituted or an unsubstituted aryle or alkenyl group; and X represents Cl or Br),
an iodonium salt expressed by the general formula 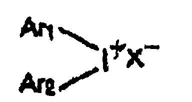 (where Ar₁ and Ar₂ represent a substituted or an unsubstituted aromatic ring; and X represents BF₆⁻, PF₆⁻, AsF₆⁻, SbF₆⁻ or ClO₄⁻, or an organic sulfonic acid anion),
a sulfonium salt expressed by the general formula 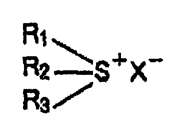 (where R₁, R₂ and R₃ represent a substituted or unsubstituted alkyl group, or an aromatic ring; X represents BF₆⁻, PF₆⁻, AsF₆⁻, SbF₆⁻ or ClO₄⁻, or an organic sulfonic acid anion),
a disulfone derivative expressed by the general formula

   **R**_{**1**}**―SO**_{**2**}**―SO**_{**2**}**―R**_{**2**}

   (where R₁ and R₂ represent a substituted aromatic ring or an alicyclic group),
an imidosulfonate derivative expressed by the general formula 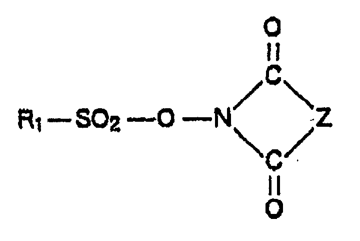 (where R₁ represents a substituted or unsubstituted alkyl group or aryl group; and Z represents a substituted or unsubstituted alkylene group, alkeneylene group or aryl group), or
a diazonium salt expressed by the general formula

   Ar₁―N₂⁺Y⁻

   (where Ar₁ represents a substituted or an unsubstituted aromatic ring; Y represents BF₆⁻, PF₆⁻, AsF₆⁻, SbF₆⁻ or ClO₄⁻, or an organic sulfonic acid anion).

In the radiation sensitive material embodying the invention comprising a copolymer expressed by the following general formula 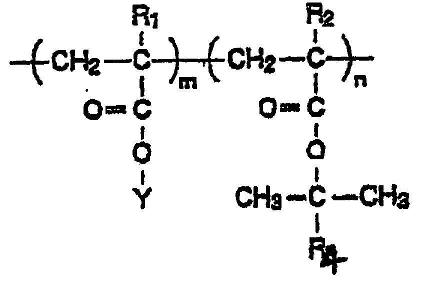 one of R1 and R2 at the α positions is not a methyl group, which is bulky and very hydrophobic, but a proton, which is small-sized and less hydrophobic. Accordingly the copolymer is then less hydrophobic and less rigid. Consequently the copolymer is more compatible with and permeable to a developer, while a protonic acid catalyst can be more diffusible. Development is therefore easier, resulting in higher sensitivity and stable patterning characteristics.

Here it is preferable that this copolymer contains a unit structure containing alicyclic groups by 40-70 mol%. In the composition with below 40 mol% of the unit structure, sufficient dry etching resistance cannot be obtained. The composition with above 70 mol% of the unit structure makes patterning difficult because of a small amount of t-butyl, a photosensitive group.

The radiation sensitive material according to the first general embodiment of the invention and whose copolymer comprises a methacrylic or acrylic acid unit expressed by the following general formula 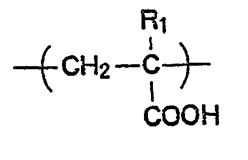 can have higher sensitivity and stable patterning characteristics because of the carboxylic acid contained in the copolymer, which is an effective hydrophilic group.

That is, because carboxylic acid is alkali soluble, the copolymer originally containing carboxylic acid becomes an alkaline aqueous solution only by substitution of the sensitive groups by a small amount of carboxylic acid. Accordingly, high sensitivity and stable patterning are characteristics can be obtained.

In the preferred radiation sensitive material according to the said first embodiment and comprising a terpolymer expressed by the following general formula 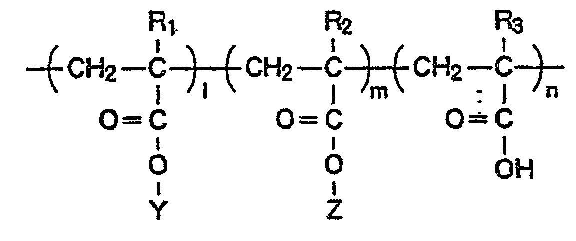 it is very effective that the terpolymer contains carboxylic acid, which is hydrophilic, because the terpolymer also contains alicyclic groups, which are very hydrophobic.

It is preferable that the terpolymer contains carboxylic acid by above 5 mol% and below 35 mol%. This is because, with a carboxylic acid content of below 5 mol%, the effect is not exhibited, and with a carboxylic acid content of above 35 mol%, even non-exposed portions are dissolved and thus patterning is impossible.

In the radiation sensitive material according to the second general embodiment of the invention and whose copolymer includes a unit structure, which is expressed by the following general formula 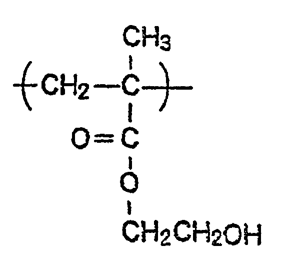 the copolymer contains hydroyethyl methacrylate as hydrophilic group, whereby, as in the case that the copolymer contains carboxylic acid, the copolymer has. higher hydrophilicity, and thus is more compatible with a developer and is permeable, resulting in higher solubility.

In the preferred radiation sensitive material according to the second embodiment and comprising a terpolymer containing a unit structure which is expressed by the following general formula 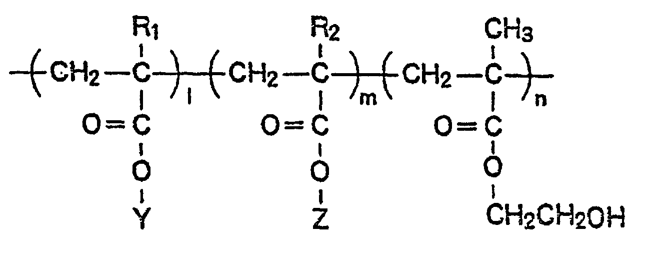 because the terpolymer contains alicyclic groups, which are very hydrophobic, it is very effective that the terpolymer contains hydroxyethyl methacrylate as a hydrophilic group.

It is preferable that the terpolymer contains hydroxyethyl methacrylate by above 5 mol% because the effect is not exhibited with a content of hydroxyethyl methacrylate below 5 mol%.

The radiation sensitive material according to the third general embodiment of the invention and comprising a copolymer including a unit structure expressed by the following general formula 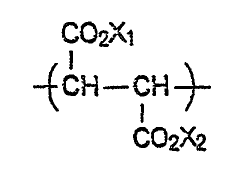 and more particularly comprising a copolymer expressed by the following general formula 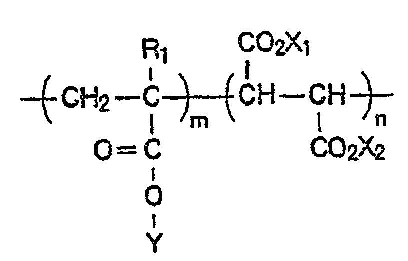 both include a unit structure expressed by 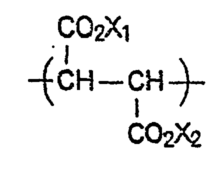 whereby a larger number of sensitive groups are available per unit structure, with the result that higher sensitivity can be obtained, resulting in stable patterning characteristics.

The radiation sensitive material according to the third general embodiment of the invention and comprising a copolymer including a unit structure expressed by the following formula 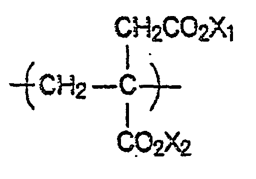 and that more particularly comprising a copolymer expressed by the following general formula 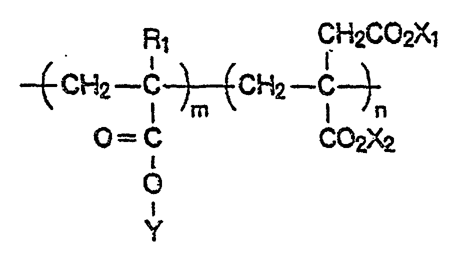 contains a relatively large number of sensitive groups per unit structure, and this enables relatively high sensitivity and stable patterning characteristics to be obtained.

For more stable patterning characteristics, it is effective to improve adhesiveness. The presence of especially adamantyl groups and t-butyl groups, which are hydrocarbon groups, degrades adhesiveness. This is because hydrocarbon-based groups have such low polarity that there is no interaction with a substrate.

Accordingly the radiation sensitive material according to the fifth general embodiment of the invention and comprising a copolymer including a unit structure expressed by the following general formula 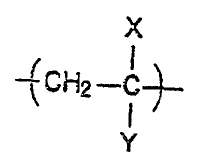 can have improved adhesiveness and stable patterning characteristics because of the nitrile groups, which have high polarity.

In the case that the unit structure including nitrile groups is acrylonitrile or methacrylonitrile, its content is preferably 10-70 mol%. When its content is below 10 mol%, sufficient adhesiveness cannot be obtained, and when its content is above 70 mol%, sufficient sensitivity cannot be obtained.

Typical of groups generating alkali soluble groups in the presence of an acid are t-butyl ester, t-amyl ester, t-butyl ether, t-BOC, tetrahydropyranyl, tetrahydropyranyl ether, 3-oxocyclohexyl ester or dimethlbenzyl ester.

That is, a resist is formed of the above-described radiation sensitive material, and the resist is applied onto a substrate to be processed, prebaked, exposed, postbaked and developed, and is subjected to other treatments, whereby a submicron dimension pattern can be formed stably.

To obtain more stable patterning characteristics, it is necessary to improve developers. Chemical amplifying resists have the intrinsic problem that protonic acid becomes inactive on the surface layers due to contamination by environmental amine, etc. Consequently solubility differences take place between the surface and inner layers, which is a serious factor that hinders stable patterning. Especially adamantyl groups, t-butyl groups, etc., Hydrocarbons, which are very hydrophobic, especially adamantyl groups, t-butyl groups, etc., are effective to hinder dissolution in developers, and are very effective at making the surface insoluble.

Accordingly, a mixed liquid of an organic alkaline aqueous solution and isopropyl alcohol is preferably used as a developer, whereby solubility is much improved and smaller solubility differences between the surface and inner layers can be obtained, so allowing stable patterning. Isopropyl alcohol is the most effective alcohol to be added as methanol and ethanol cause cracks, and peeling takes place. The use of this liquid mixture developer raised the sensitivity by one or more places and reduced strain caused upon development, so that the adhesiveness was much improved.

It is preferable that the developer contains isopropyl alcohol by 5 - 95 vol%. This is because content of isopropyL alcohol by below 5 mol% does not improve the sensitivity, and content above 95 mol% easily causes cracks and crazes.

### BRIEF DESCRIPTION OF THE DRAWINGS

FIG. 1 is a flow chart of one example of the semiconductor fabrication method according to the present invention;
FIGs. 2A to 2G are sectional views of a semiconductor device in the steps of one example of the semiconductor fabrication method according to the present invention;
FIG. 3 is the flow chart of another example of the semiconductor fabrication method according to the present invention;
FIGs. 4A to 4H are sectional views of a semiconductor device in the steps of another example of the semiconductor fabrication method according to the present invention.

### DETAILED DESCRIPTION OF THE PREFERRED EMBODIMENTS

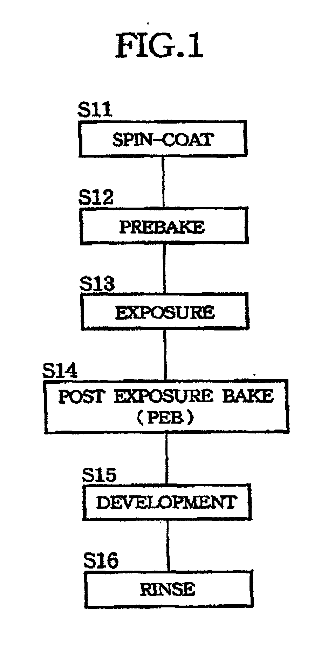

An example of the semiconductor fabrication method according to the present invention will be explained with reference to FIGs. 1, and 2A to 2G.

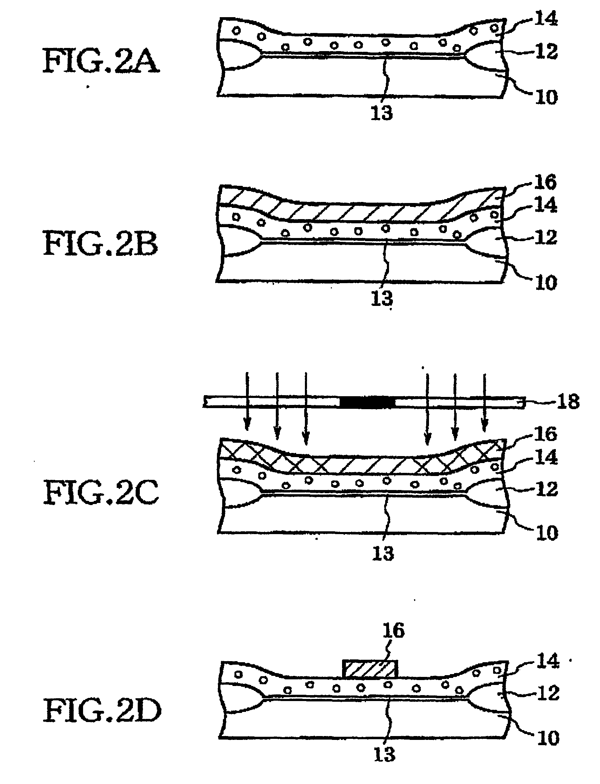

In patterning a polycrystalline silicon film 14 deposited through an oxide film 13 on a semiconductor substrate 10 with a field isolation 12 formed on as shown in FIG. 2A, a resist film 16 is applied to the semiconductor substrate 10 with a polycrystalline silicon film 14 formed on (Step S11), and prebaked (Step S12) (FIG. 2B).

Then, the semiconductor substrate 10 with the resist film 16 deposited on is exposed through a mask 18 for selective exposure (Step S13, FIG. 2C).

Following postbake (Step S14), the resist film 16 is developed with a developer (Step S15) and patterned. Subsequently the semiconductor substrate 10 is rinsed with deionized water (Step S16). Thus the patterned resist film 16 is formed on the semiconductor substrate 10 (FIG. 2D).

Then, with the patterned resist film 16 as a mask; the polycrystalline silicon film 14 is etched by reactive ion etching (FIG. 2E).

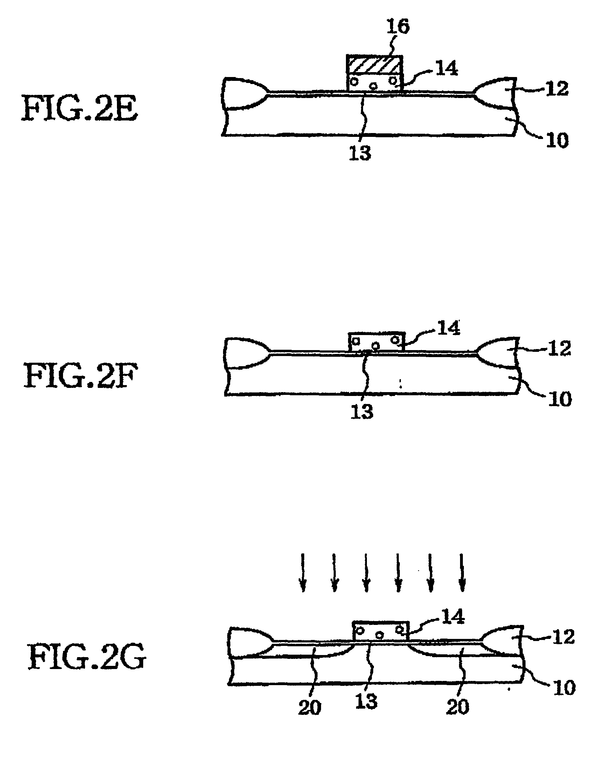

Next, the resist film 16 is removed, and the patterning of the polycrystalline silicon film 14 is completed (FIG. 2F).

Subsequently ion implantation is conducted with the polycrystalline silicon film 14 as a mask to form a source / drain diffusion 20, and a MOS transistor including the polycrystalline silicon film 14 as a gate electrode is fabricated (Fig. 2G).

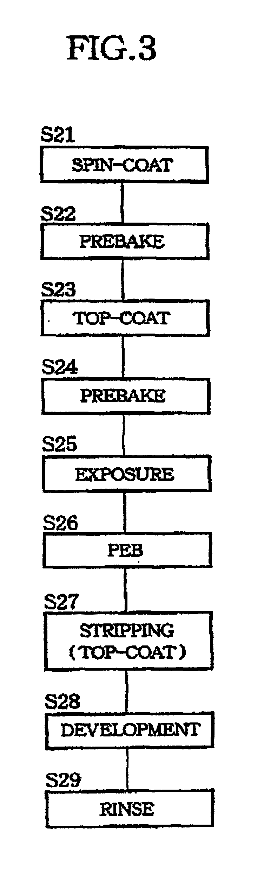

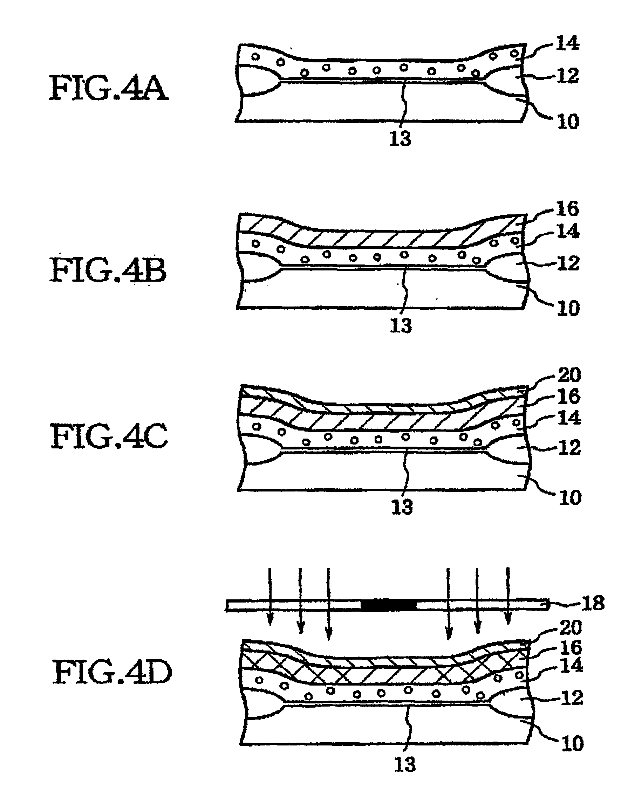

Another example of the semiconductor fabrication method according to the present invention will be explained with reference to FIGs. 3, and 4A to 4H.

In patterning a polycrystalline silicon film 14 deposited through an oxide film 13 on a semiconductor substrate 10 with a field isolation 12 formed on as shown in FIG. 4A, a resist film 16 is applied to the semiconductor substrate 10 with a polycrystalline silicon film 14 formed on (Step S21), and prebaked (Step S22, FIG. 4B).

Next, a protecting film 20 (top coat) is applied onto the semiconductor substrate 10 by spin coating (step S23), and prebaked (Step S24, Fig. 4C)

Then, the semiconductor substrate 10 with the resist film 16 and the protecting film 20 deposited on is exposed through a mask 18 for selective exposure (Step S25, FIG. 4D).

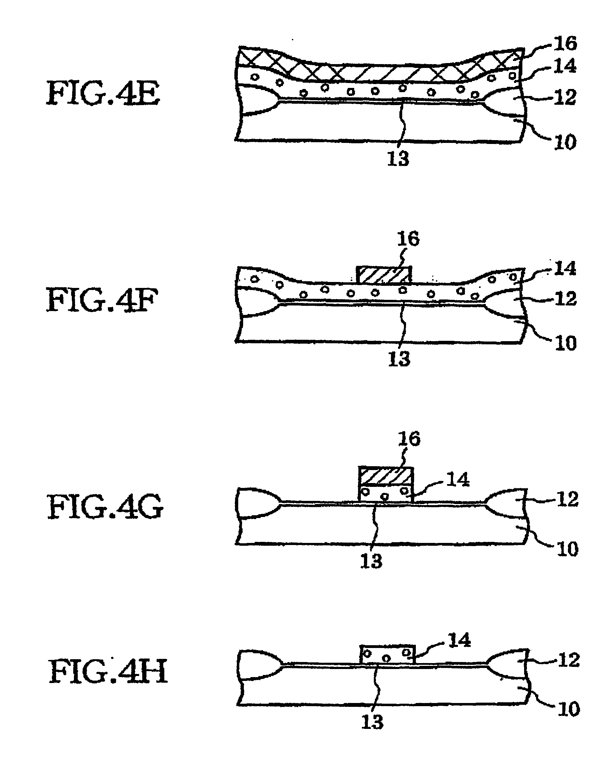

Following postbake (Step S26), chemical solution which can dissolve the protecting film 20 is applied onto the semiconductor substrate 10 by spin coating, and the protecting film 20 is stripped (Step S27, Fig. 4E).

Next, the resist film 16 is developed with a developer (Step S28) and patterned. Subsequently the semiconductor substrate 10 is rinsed with deionized water (Step S29). Thus the patterned resist film 16 is formed on the semiconductor substrate 10 (FIG. 4F).

Then, with the patterned resist film 16 as a mask, the polycrystalline silicon film 14 is etched by reactive ion etching (FIG. 4G).

Next, the resist film 16 is removed, and 'the patterning of the polycrystalline silicon film 14 is completed (FIG. 4H).

As described above, subsequently ion implantation is conducted with the polycrystalline silicon film 14 as a mask to form a source / drain diffusion 20, and a MOS transistor including the polycrystalline silicon film 14 as a gate electrode is fabricated.

Accordingly micronized semiconductor device can be fabricated by excimer laser lithography, which can provide highly sensitive, stable patterning characteristics.

### [Example 1]

Adamantyl methacrylate monomer, and t-butyl acrylate monomer were loaded by 1:1, and a 5 mol/l toluene solution was prepared. 20 mol% of AIBN (azoisobutylo nitrile) expressed by the following structural formula 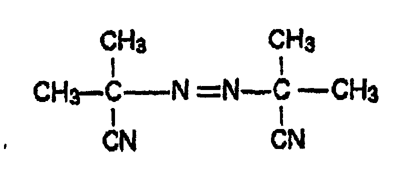 was added as a polymerization initiator. Then polymerization was reacted at 80°C for 8 hours, and precipitation purification followed. And a copolymer expressed by the following structural formula 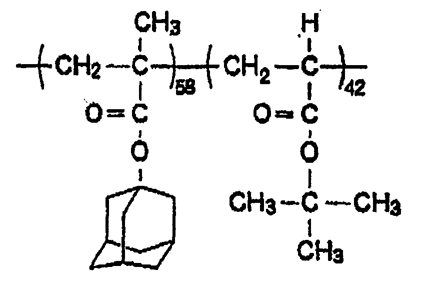 and having a 58:42 composition ratio, a 5100 weight-averaged molecular weight (Mw) and a 1.43 (Mw/Mn) was prepared. A thermal analysis showed that the glass transition temperature of this polymer was 126°C.

Then triphenylsulfonium hexafluoroantimonate expressed by the following structural formula 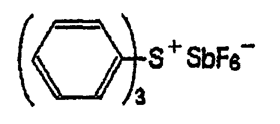 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate at 60°C.

The thus-prepared resist film on the wafer was exposed by KrF excimer stepper (by Nikon, NA=0.45) and then was subjected to PEB (Post Exposure Bake) at 100°C for 60 seconds. Subsequently the resist was developed for 60 seconds by NMD-3 (by Tokyo Ohka), which is an alkaline aqueous solution and rinses by deionized water for 30 seconds. A threshold energy Eth of the radiation dose for this exposure was 50 mJ/cm². A 0.45 µm-wide L & S (line and space) pattern was formed at a 130 mJ/cm² radiation dose.

### [Example 2]

Adamantyl acrylate monomer and t-butyl methacrylate monomer were loaded by 1:1, and a 5 mol/l toluene solution was prepared. 20 mol% of AIBN (azoisobutylo nitrite) was added as a polymerization initiator. Then polymerization was reacted at 80°C for 8 hours, and precipitation purification followed. And a copolymer expressed by the following structural formula 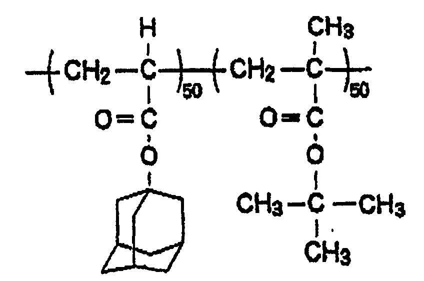 and having a 50:50 composition ratio, a 4180 weight-averaged molecular weight and a 1.59 degree of dispersion was prepared. A thermal analysis showed that the glass transition temperature of this polymer was 94°C.

Then triphenylsulfonium hexafluoroantimonate expressed by the following structural formula 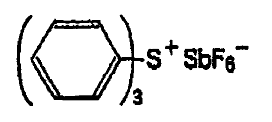 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 81 mJ/cm². A 0.50 µm-wide L & S pattern was formed.

### [Example 3]

Adamantyl acrylate monomer, and t-butyl acrylate monomer were loaded by 1:1, and a 5 mol/l toluene solution was prepared. 20 mol% of AIBN was added as a polymerization initiator. Then polymerization was reacted at 80°C for 8 hours, and precipitation purification with methanol followed. And a copolymer expressed by the following structural formula 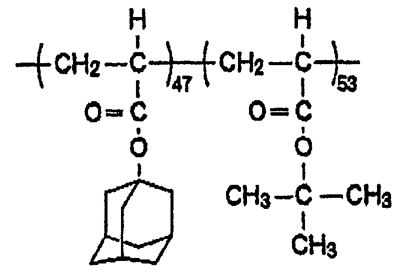 and having a 47:53 composition ratio, a 4610 weight-average molecular weight and a 1.83 degree of dispersion was prepared. A thermal analysis showed that the glass transition temperature of this polymer was 72°C.

Then triphenylsulfonium hexafluoroantimonate expressed by the following structural formula 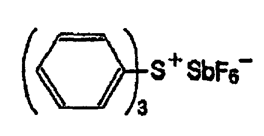 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 37 mJ/cm². A 0.50 µm-wide L & S pattern was formed.

### [Control 1]

Adamantyl methacrylate monomer, and t-butyl methacrylate monomer were loaded by 1:1, and a 5 mol/l toluene solution was prepared. 20 mol% of AIBN was added as a polymerization initiator. Then polymerization was reacted at 80°C for 8 hours, and precipitation purification followed. And a copolymer expressed by the following structural formula 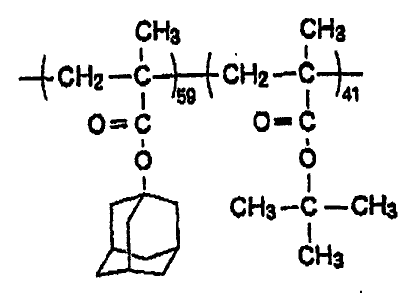 and having a 59:41 composition ratio, a 3351 weight-average molecular weight and a 1.31 degree of dispersion was prepared. No glass transition temperature of this polymer was found by a thermal analysis.

Then triphenylsulfonium hexafluoroantimonate expressed by the following structural formula 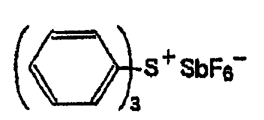 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. The development did not advance, and no pattern was formed.

### [Control 2]

Adamantyl methacrylate monomer, and t-butyl methacrylate monomer were loaded by 1:1, and a 5 mol/l toluene solution was prepared. 20 mol% of AIBN was added as a polymerization initiator. Then polymerization was reacted at 80°C for 8 hours, and precipitation purification followed. And a copolymer expressed by the following structural formula 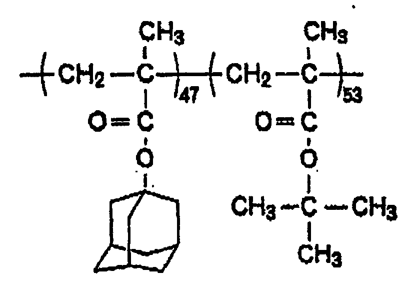 and having a 47:53 composition ratio, a 19000 weight-averaged molecular weight and a 1.51 degree of dispersion was prepared. No glass transition temperature of this polymer was found by a thermal analysis.

Then triphenylsulfonium hexafluoroantimonate expressed by the following structural formula 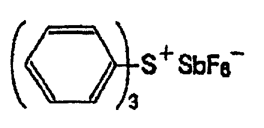 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. An exposed region was reduced to about 10 % at a radiation dose of 102 mJ/cm², but the residual film did not disappear even at higher exposures.

### [Example 4]

Dimethyladamantyl acrylate monomer, and t-butyl methacrylate monomer were loaded by 1:1, and a 5 mol/l toluene solution was prepared. 20 mol% of AIBN (azoisobutylo nitrile) was added as a polymerization initiator. Then polymerization was reacted at 80°C for 8 hours, and precipitation purification followed. And a copolymer expressed by the following structural formula 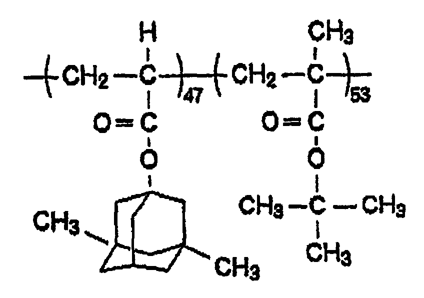 and having a 47:53 composition ratio, a 3650 weight-averaged molecular weight and a 1.64 degree of dispersion was prepared. A thermal analysis showed that the glass transition temperature of this polymer was 66°C.

Then triphenylsulfonium hexafluoroantimonate expressed by the following structural formula 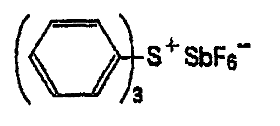 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 81 mJ/cm². A minimum resolution was a 0.35 µm-wide L & S.

### [Example 5]

Dimethyladamantyl acrylate monomer, and t-butyl acrylate monomer were loaded by 1:1, and a 5 mol/l toluene solution was prepared. 20 mol% of AIBN (azoisobutylo nitrile) was added as a polymerization initiator. Then polymerization was reacted at 80°C for 8 hours, and precipitation purification followed. And a copolymer expressed by the following structural formula 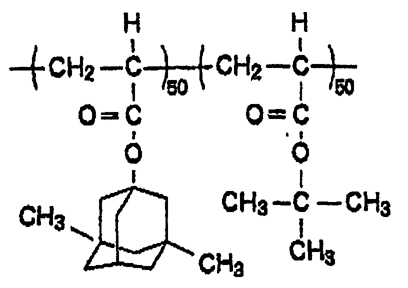 and having a 50:50 composition ratio, a 4050 weight-averaged molecular weight and a 1.71 degree of dispersion was prepared. A thermal analysis showed that the glass transition temperature of this polymer was 47°C.

Then triphenylsulfonium hexafluoroantimonate expressed by the following structural formula 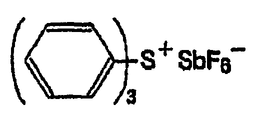 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 81 mJ/cm². A minimum resolution was a 0.30 µm-wide L & S.

### [Control 3]

Adamantyl methacrylate monomer, and t-butyl methacrylate monomer were loaded by 3:7, and a 5 mol/l toluene solution was prepared. 20 mol% of AIBN (azoisobutylo nitrile) was added as a polymerization initiator. Then polymerization was reacted at 80°C for 8 hours, and precipitation purification followed. And a copolymer expressed by the following structural formula 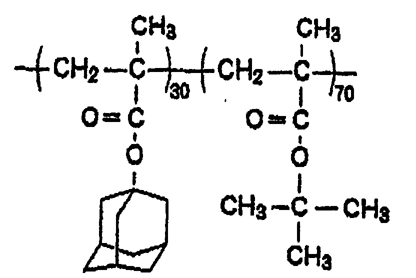 and having a 30:70 composition ratio, a 8400 weight-averaged molecular weight and a 1.61 degree of dispersion was prepared. No glass transition temperature of this polymer was not found by a thermal analysis.

Then triphenylsulfonium hexafluoroantimonate expressed by the following structural formula 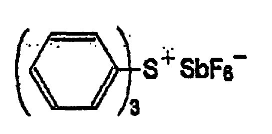 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 81 mJ/cm². A minimum resolution was a 0.50 µm-wide L & s, and smaller patterns peeled off and could not be found.

### [Example 6]

Adamantyl methacrylate monomer, t-butyl methacrylate monomer and methacrylic acid were loaded by 2:1:1. 0.5 mol/l 1,4-dioxane solution was used, and 20 mol% of AIBN was added as a polymerization initiator. Then polymerization was reacted at 80°C for 8 hours, and precipitation purification with n-hexane followed. And a terpolymer expressed by the following structural formula 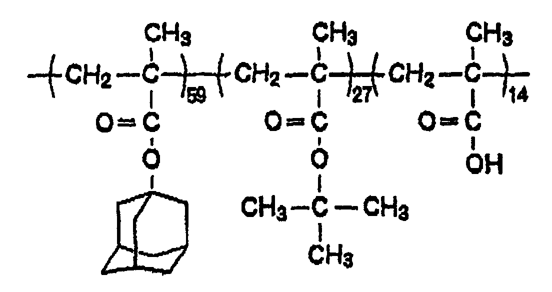 and having a 59:27:14 composition ratio, a 6242 weight-averaged molecular weight and a 2.14 degree of dispersion was prepared.

Then triphenylsulfonium hexafluoroantimonate expressed by the following structural formula 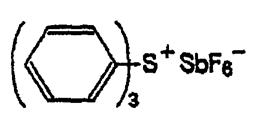 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate.

The thus-prepared resist film on the wafer was exposed by KrF excimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 100 mJ/cm². A 0.45 µm-wide L & S pattern was formed.

### [Example 7]

A profile of the 1 µm hole pattern prepared according to Example 6 was observed. The result of the observation was no unsolved superficial layer was found. Even when the resist film was exposed and then left for 45 minutes, and was subjected to PEB, the pattern was not formed.

### [Control 4]

Adamantyl methacrylate monomer, and t-butyl acrylate monomer were loaded by 1:1, and 5 mol/l toluene solution was prepared. 20 mol% of AIBN was added as a polymerization initiator. The polymerization was reacted for about 8 hours at 80°C. The polymerization was followed by precipitation purification with methanol. Resultantly a copolymer expressed by 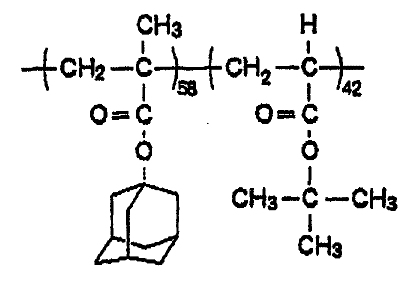 and having a composition ratio of 59:42, a 5100 weight-average molecular weight, and a 1.43 degree of dispersion was prepared. The glass transition temperature of this copolymer given by thermal analysis was 126°C.

Then triphenylsulfonium hexafluoroantimonate expressed by the following structural formula 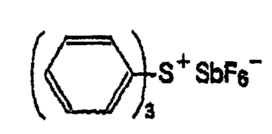 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate.

The thus-prepared resist film on the wafer was exposed by KrF exoimer stepper and then was subjected to PEB at 100°C for 60 seconds. Subsequently the resist was developed for 60 seconds by NMD-3, which is an alkaline aqueous solution and rinsed by deionized water for 30 seconds. A threshold energy Eth of the radiation dose for this exposure was 50 J/cm². A 0.45 µm wide L & S pattern was formed at 130 mJ/cm². The profile of a 1 µm hole pattern had "eaves" of an unsolved superficial layer.

### [Control 5]

In Control 4, after the exposure, the resist film was left for 45 minutes and was subjected to PEB. A substantially upper half of the pattern was covered with the superficial unsolved layer. Accordingly the pattern could not be formed.

### [Example 8]

Adamantyl methacrylate monomer, t-butyl methacrylate monomer and methacrylic acid were loaded by 2:1:1, and 0.5 mol/l 1,4-dioxane solution was prepared. 20 mol% of AIBN was added as a polymerization initiator. Then polymerization was reacted at 80°C for about 8 hours, and precipitation purification with n-hexane followed. And a terpolymer expressed by the following structural formula 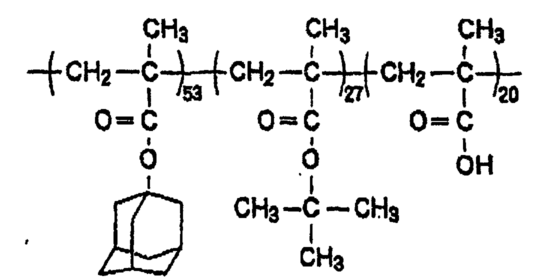 and having a 53:27:20 composition ratio, a 4523 weight-averaged molecular weight and a 1.92 degree of dispersion was prepared.

Then triphenylsulfonium hexafluoroantimonate expressed by the following structural formula 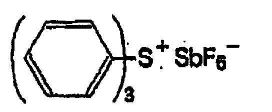 was addled as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 130°C.

The thus-prepared resist film on the wafer was exposed by KrF excimer stepper and then was subjected to PEB at 130°C for 60 seconds. Subsequently the resist was immersed for 90 seconds in an NMD-3 solution, an alkaline aqueous solution, diluted by a 20-time amount of deionized water and developed, and then rinsed with deionized water for 30 seconds. The threshold energy Eth of the radiation dose for this exposure was 57 mJ/cm². A 0.30 µm-wide L & S pattern was formed.

### [Control 6]

Adamantyl methacrylate monomer, t-butyl methacrylate monomer and methacrylic acid were loaded by 2:1:4, and 0.5 mol/l 1,4-dioxane solution was prepared. 20 mol% of AIBN was added as a polymerization initiator. Then polymerization was reacted at 80°C for about 8 hours, and precipitation purification with n-hexane followed. And a terpolymer expressed by the following structural formula 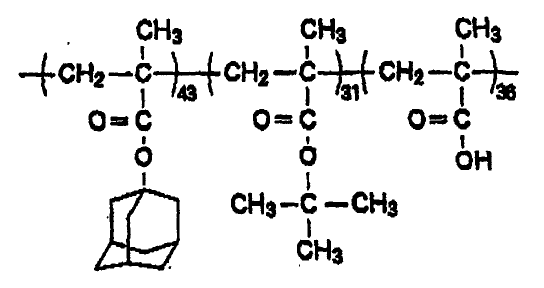 and having a 43:31:36 composition ratio, a 4115 weight-averaged molecular weight and a 1.95 degree of dispersion was prepared.

Then triphenylsulfonium hexafluoroantimonate expressed by the following structural formula 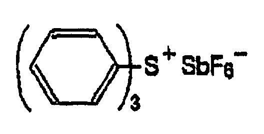 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 130°C.

The thus-prepared reeist film on the wafer was exposed by KrF excimer stepper and then was subjected to PEB at 130°C for 60 seconds. Subsequently the resist was immersed for 90 seconds in an NMD-3 solution, an alkaline solution, diluted by a 20-time amount of deionized water, and the resist film disappeared.

### [Example 9]

To adamantyl methacrylate - t-butyl methacrylate - hydroxyethyl methacrylate terpolymer expressed by the following structural formula 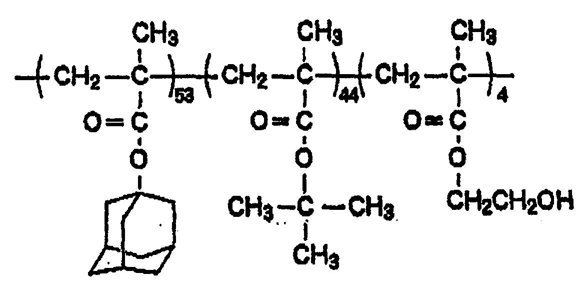 and having a composition ratio of 53:44:4, a 8800 weight-average molecular weight and a 1.84 degree of dispersion, 15 wt% of triphenylsulfonium hexafluoroantimonate expressed by the following structural formula 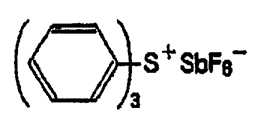 was added as an acid generating substance to prepare a cyclohexanone solution. This solution was applied to an Si wafer treated with HMDS (hexamethyldisilazane) and then baked on a hot plate of 60°C for 100 seconds. And a 0.65 µm-thickness resist film was prepared.

The thus-prepared resist film was exposed by a KrF excimer stepper and was subjected to PEB at 130°C for 60 seconds. Subsequently the resist film was developed with an aqueous solution of 2.38 % of TMAH (tetramethyl ammonium hydroxide). The radiation dose for this exposure was 110 mJ/cm². A 0.4 µm-wide L & S pattern was resolved.

### [Example 10]

To adamantyl methacrylate - t-butyl methacrylate - hydroxyethyl methacrylate terpolymer expressed by the following structural formula 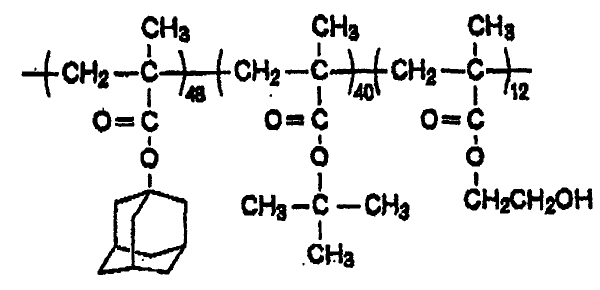 and having a composition ratio of 48:40:12, a 8400 weight-average molecular weight and a 1.94 degree of disperaion, 15 wt% of triphenylsulfonium hexafluoroantimonate expressed by the following structural formula 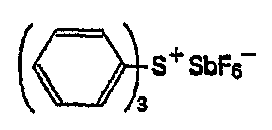 was added as an acid generating substance to prepare a cyclohexanone solution. This solution was applied to an Si wafer treated with HMDS (hexamethyldisilazane) and then baked on a hot plate of 60°C for 100 seconds. And a 0.65 µm-thickness resist film was prepared.

The thus-prepared resist film was exposed by a KrF excimer stepper and was subjected to PEB at 130°C for 60 seconds. Subsequently the resist film was developed with an aqueous solution of 2.38 % of TMAH (tetramethylammonium hydroxide). The radiation dose for this exposure was 40 mJ/cm². A 0.4 µm-wide L & S pattern was resolved.

### [Control 7]

To adamantyl methacrylate-t-butyl methacrylate copolymer expressed by the following structural formula 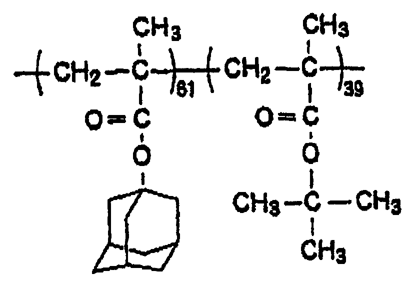 and having a composition ratio of 61:39, a 7900 weight-average molecular weight and a 1.82 degree of dispersion, 15 wt% of triphenylsulfonium hexafluoroantimonate expressed by the following structural formula 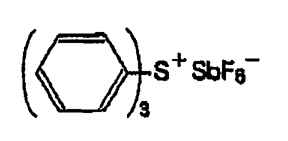 was added as an acid generating substance to prepare a cyclohexanone solution. This solution was applied, by spin ooating, to a wafer coated with hard-baked novolak and baked on a hot plate of 60°C for 100 seconds. And a 0.65 µm-thickness resist film was formed.

The thus-prepared resist film was exposed by a KrF excimer stepper and was subjected to PEB at 100°C for 60 seconds. Subsequently the resist film was developed with an aqueous solution of 2.38 % of TMAH (tetramethylammonium hydroxide). The radiation dose for this exposure was 40 mJ/cm². A 0.4 µm-wide L & S pattern was resolved, but the pattern could not be reproduced.

### [Example 11]

Adamantyl methacrylate monomer, and di-t-butyl itaconate monomer were loaded by 1:3. 20 mol% of MAIB (dimethyl 2,2-azoisobisbutylate) expressed by the following structural formula 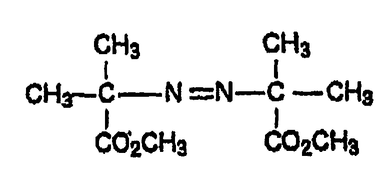 was added as a polymerization initiator. Then, bulk polymerization followed at 80°C for about 3 hours. The polymerization was followed by precipitation purification with methanol.

Resultantly the copolymer expressed by the following structural formula 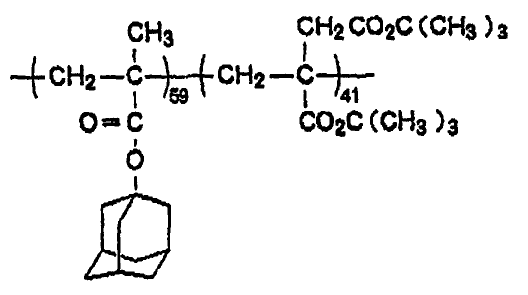 and having a composition ratio of 59:41, a weight-average molecular weight of 9357 and a 2.44 degree of dispersion was prepared.

Then triphenylsulfonium hexafluoroantimonate expressed by the following structural formula 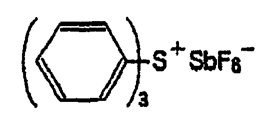 was added as an acid generating substance by 15 wt% to the thus-synthesized copolymer, and a cyclohexanone solution was prepared. This solution was applied, in a 0.7 µm-thickness by spin coating, to an HMDS treated Si wafer, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds with NMD-3, which is a alkaline aqueous solution, and then rinsed with deionized water for 30 seconds. The threshold energy Eth of the radiation dose for this exposure was 5.6 mJ/cm². A resolution was a 0.7 µm-wide L & S pattern.

### [Control 8]

Adamantyl methacrylate monomer, and t-butyl acrylate monomer were loaded by 1:1. 20 mol% of MAIB expressed by the following structural formula 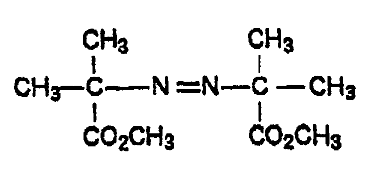 was added as a polymerization initiator. Then, bulk polymerization followed at 80°C for about 3 hours with toluene as a reaction solvent. The polymerization was followed by precipitation purification with methanol.

Resultantly the copolymer expressed by the following structural formula 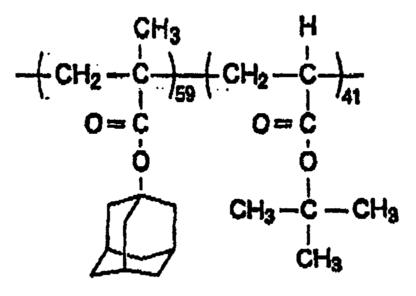 and having a composition ratio of 59:41, a weight-average molecular weight of 6061 and a 1.24 degree of dispersion was prepared.

Then triphenylsulfonium haxafluoroantimonate expressed by the following structural formula 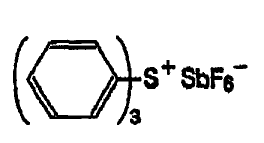 was added as an acid generating substance by 15 wt% to the thus-synthesized copolymer, and a cyclohexanone solution was prepared. This solution was applied, in a 7 µm-thickness by spin coating, to an HMDS treated Si wafer, and prebaked for 100 seconds on a hot plate of 60°C.

The thus-prepared resist film on the wafer was exposed by KrF excimer stepper and then was subjected to PEB at 100°C for 60 seconds. subsequently the resist was. developed for 60 seconds with NMD-3, which is a alkaline aqueous solution, and then rinsed with deionized water for 30 seconds. The threshold energy Eth of the radiation dose for this exposure was 25.1 mJ/cm². A minimum resolution was a 0.5 µm-wide L & S pattern.

### [Example 12]

Adamantyl methacrylate monomer, and di-t-butyl fumarate monomer were loaded by 1:3, and 20 mol% of MAIB expressed by the following structural formula 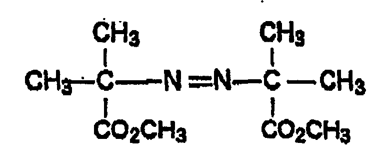 was added. Them bulk polymerization followed at 80°C for about 25 hours. The polymerization was followed by precipitation purification with methanol. Resultantly the copolymer expressed by the following structure formula 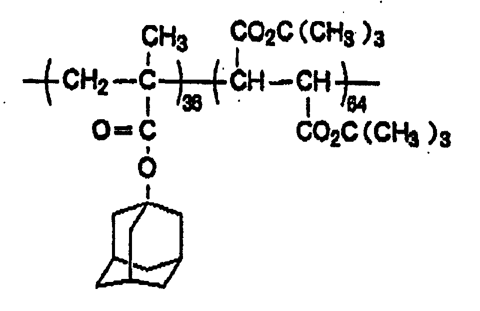 and having a composition ratio of 36:64 and a weight-average of 22645 and a 2.44 degree of dispersion was prepared.

Then triphenylsulfonium hexafluoroantimonate expressed by the following structural formula 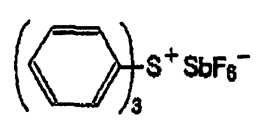 was added as an acid generating substance by 15 wt% to the thus-synthesized copolymer, and a cyclohexanone solution was prepared. This solution was applied, in a 0.7 µm-thickness by spin coating, to an HMDS treated wafer, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds with NMD-3, which is a alkaline aqueous solution, and then rinsed with deionized water for 30 seconds. The threshold energy Eth of the radiation dose for this exposure was 5 mJ/cm². A resolution was a 0.5 µm-wide L & S pattern.

### [Control 9]

To the adamnatylacrylate - t-butyl methacrylate copolymer expressed by the following structural formula 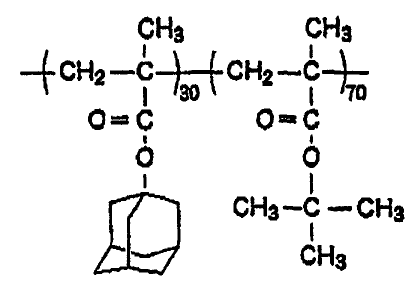 and having a composition ratio of 30:70, a weight-averaged molecular weight of 844 and a 1.61 degree of dispersion, 15 wt% of triphenylsulfonium hexafluoroantimonate expressed by the following structural formula 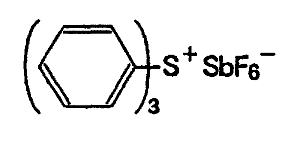 as a polymerization initiator was added, and a cyclohexanone solution was prepared. This solution was applied, by spin coating, to a wafer coated with hard-baked novolak and baked on a hot plate of 60°C for 100 seconds. And a 0.7 µm-thickness resist film was formed.

The thus-prepared resist film on the wafer was exposed by KrF excimer stepper, then subjected to PEB at 100°C for 60 seconds, and developed with a 2.38% TMAH aqueous solution, The threshold energy Eth of the radiation dose for this exposure was 15 mJ/cm². A 0.4 µm-wide L & S pattern -was resolved, and the pattern could not be reproduced.

### [Example 13]

Three kinds of monomers of methacrylonitrile, t-butyl methacrylate, and adamantyl methacrylate were loaded by 1:2:1, and 1 mol/l of a solvent, 1,4-dioxane, and 1 mol% of AIBN, a polymerization initiator were added. Polymerization was reacted at 80°C for about 8 hours. The polymerization was followed by precipitation purification with an aqueous solution of methanol (methanol : water = 2:1). Resultantly the terpolymer expressed by the following structural formula 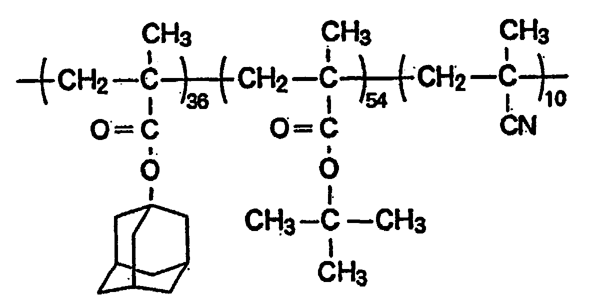 and having a composition ratio of 10:54:36, a weight-averaged molecular weight 5750 and a 1.21 degree of dispersion was prepared.

The thus-prepared resist film on the wafer was exposed by KrF excimer stepper, and then immersed in 2.38% TMAH aqueous solution for 60-seconds for development. A 0.7 µm-wide L & S pattern was resolved at a 250 mJ/cm² radiation dose.

### [Example 14]

Adamantyl methacrylate monomer and t-butyl methacrylate monomer were loaded by 1:1, and 5 mol/l toluene solution was prepared. 20 mol% of AIBN was added as a polymerization initiator. Then polymerization was effected at 80°C for about 8 hours, and precipitation purification with methanol followed. A copolymer expressed by the following structural formula 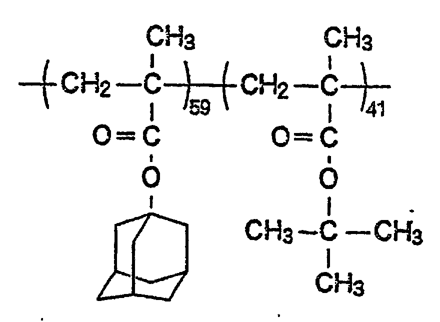 and having a 59:41 composition ratio, a 3351 weight-average molecular weight and a 1.31 degree of dispersion was prepared. No glass transition temperature of this polymer was found by a thermal analysis.

Then triphenylsulfonium hexafluoroantimonate expressed by the following structural formula 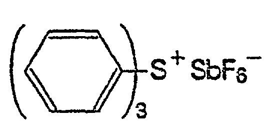 was added as an acid generating substance by 15 wt% to the thus-synthesized copolymer, and a cyclohexanone solution was prepared. This solution was applied by spin coating in a 0.7 µm-thickness onto a wafer coated with hard-baked novolak resin, and prebaked for 100 seconds on a hot plate of 60°C.

The thus-prepared resist film on the wafer was exposed by KrF excimer stepper and then was subjected to PEB at 100°C for 60 seconds. Subsequently the resist was developed for 60 seconds with mixed liquid of an alkaline aqueous solution, NMD-3 and isopropyl alcohol mixed by a volume ratio of 1:1, and rinsed with deionized water for 30 seconds. The threshold energy Eth of the radiation dose for this exposure was 8 mJ/cm². The minimum resolved pattern was a 0.30 µm-wide L & S.

### [Example 15]

The same process as in Example 14 was conducted. As a development liquid, the mixed liquid in Example 18 was replaced by mixed liquid of NMD-3 and isopropyl alcohol mixed by a volume ratio of 3:3 was used. A 0.40 µm-wide L & S pattern was resolved at a 42 mJ/cm² radiation dose.

### [Example 16]

The same process as in Example 14 was conducted. As a development liquid, the mixed liquid in Example 18 was replaced by mixed liquid of NMD-3 and isopropyl alcohol mixed by a volume ratio of 9:1 was used. A 0.40 µm-wide L & S pattern was resolved at a 98 mJ/cm² radiation dose.

### [Control 10]

The same process as in Example 14 was conducted. As a developer, the mixed liquid in Example 14 was replaced by isopropyl alcohol. A pattern completely peeled off.

### [Example 17]

2-norbornyl methacrylate monomer, t-butyl methacrylate monomer, and methacrylic acid were loaded in a ratio of 2:1:1. 0.5 mol/1 of a solvent, 1,4-dioxane and 20 mol% of a polymerization initiator AIBN were added, and polymerization took place for about 9 hours at 80°C. After the polymerization, precipitation purification was conducted with n-hexane. A terpolymer expressed by the following structural formula 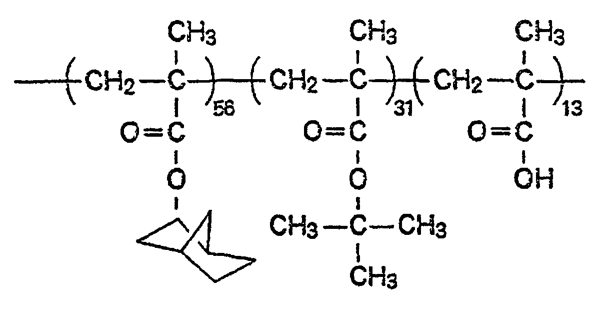 and having a composition ratio of 56:31:13 and a 5833 weight-average molecular weight and 2.34 degree of dispersion was prepared.

Then to the thus-synthesized polymer, 15 wt% of triphenylsulfonium hexafluoroantimonate as an acid generating substance expressed by the following structural formula 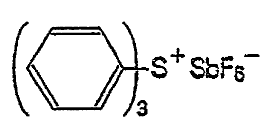 was added, and a cyclohexanone solution was prepared. This solution was applied onto a wafer coated with hard-baked novolak resin, in a 0.7 µm-thickness by spin coating, and the wafer was prebaked on a hot plata at 60°C for 100 seconds.

The thus-prepared resist film on the wafer was exposed by a KrF excimer stepper and then subjected to PEB at 100°C for 60 seconds. Subsequently the resist was developed for 60 seconds with NMD-3, an alkali aqueous solution, and then rinsed with deionized water for 30 seconds. The threshold energy Eth of the radiation dose for this exposure was 63 mJ/cm². A minimum resolution was a 0.35 µm-wide L & S pattern.

### [Example 18]

Di-t-butyl itaconate monomer and cyclohexyl methacrylate monomer were loaded in a 3:1 ration, and 20 mol% of MAIB was added. Then bulk polymerization took place at 80°C for about 10.5 hours. The bulk polymerization was followed by precipitation purification with methanol. And the copolymer expressed by the following structural formula 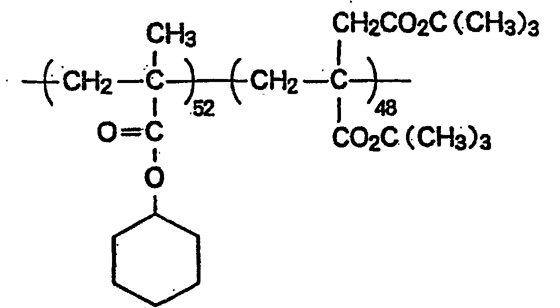 and having a 52:48 composition ratio, a 6923 weight-average molecular, weight and a 2.12 degree of dispersion was prepared.

Then to the thus-synthesized polymer, 15 wt% of triphenylsulfonium hexafluoroantimonate as an acid generating substance expressed by the following structural formula 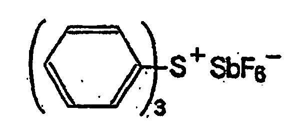 was added, and a cyclohexanone solution was prepared. This solution was applied onto an HMDS treated wafer in a 0.7 µm-thickness by spin coating, and the wafer was prebaked on a hot plate at 60°C for 100 seconds.

The thus-prepared resist film on the wafer was exposed by a KrF excimer stepper and then subjected to PEB at 100°C for 60 seconds. Subsequently the resist was developed for 60 seconds with NMD-3, an alkali aqueous solution, and then rinsed with deionized water for 30 seconds. The threshold energy Eth of the radiation dose for this exposure was 9.52 mJ/cm². A minimum resolution was a 0.5 µm-wide L & S pattern.

### [Example 19]

A 15 wt% cyclohexanone solution of t-butyl methacrylate - adamantyl acrylate - methacrylic acid terpolymer expressed by the following structural formula 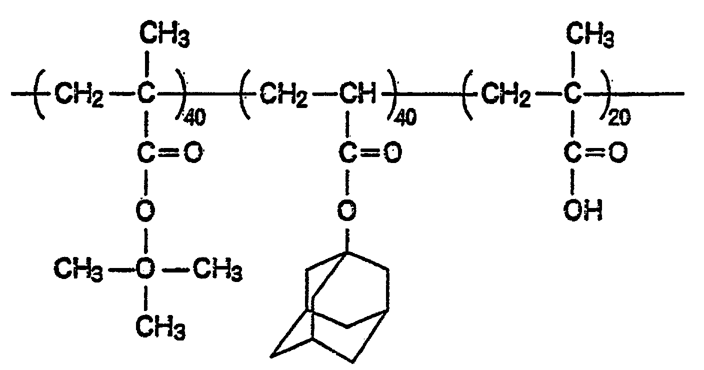 and having a 40:40:20 composition ratio was prepared. Triphenylsulfonium hexafluoroantimonate as an acid generating substance was added to the solution by 2 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

A solution of 5 wt% of polyolefine resin in p-cymene was applied onto the wafer by spin coating and baked for 100 seconds on a hot plate at 100°C, and a 0.2 µm-thickness protecting film was formed.

The thus-coated resist film on the wafer was exposed by a KrF excimer stepper and was subjected to PEB at 150°C for 60 seconds. Then cyclohexane was applied onto the wafer by spin coating, and the protecting film was removed.

Then the wafer was immersed for 60 seconds in a 2.38 % TMAH aqueous solution for development.

A 0.3 µm-wide L & S pattern was resolved at a 35 mJ/cm² radiation dose.

### [Control 11]

A 15 wt% cyclohexanone solution of t-butyl methacrylate - adamantyl acrylate copolymer expressed by the following structural formula 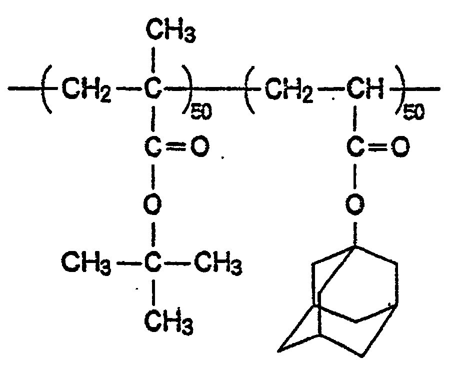 and having a 50:50 composition ratio was prepared. Triphenylsulfonium hexafluoroantimonate as an acid generating substance was added to the solution by 2 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

A solution of 5 wt% of polyolefine resin in p-cymene was applied onto the wafer by spin coating, then the resist thin film was resolved.

### [Control 12]

A 15 wt% cyclohexanone solution of t-butyl methacrylate - adamantyl acrylate - methacrylic acid terpolymer expressed by the following structural formula 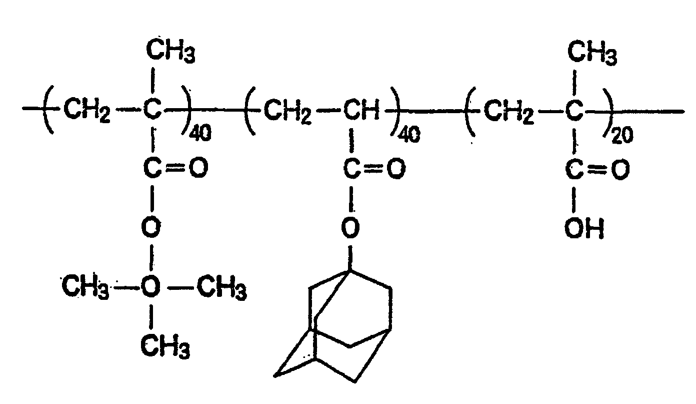 and having a 40:40:20 composition ratio was prepared. Triphenylsulfonium hexafluoroantimonate as an acid generating substance was added to the solution by. 2 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

A solution of 5 wt% of polyolefine resin in xylene was applied onto the wafer by spin coating, then the resist film was resolved.

### [Example 20]

A 15 wt% cyclohexanone solution of t-butyl methacrylate - norbornyl methacrylate - hydroxyethyl methacrylate terpolymer expressed by the following structural formula 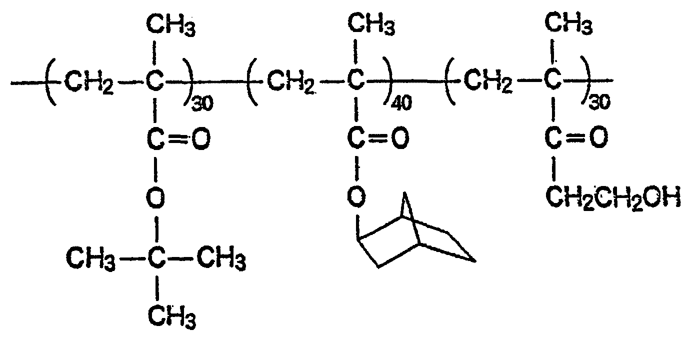 and having a 30:40:30 composition ratio was prepared. Triphenylsulfonium hexafluoroantimonate as an acid generating substance was added to the solution by 5 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

A solution of 5 wt% of polydiene resin in 1-dacene expressed by the following structural formula 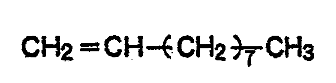 was applied onto the wafer by spin coating and baked for 100 seconds on a hot plate at 100°C, and a 0.2 µm-thickness protecting film was formed.

The thus-coated resist film on the wafer was exposed by a KrF excimer stepper and was subjected to PEB at 150°C for 60 seconds. Then cyclohexane was applied onto the wafer by spin coating, and the protecting film was stripped.

Then the wafer was immersed for 60 seconds in a 2.38 % TMAH aqueous solution for development.

A 0.3 µm-wide L & S pattern was resolved at a 40 mJ/cm² radiation dose.

### [Control 13]

A 15 wt% cyclohexanone solution of t-butyl methacrylate - norbornyl methacrylate copolymer expressed by the following structural formula 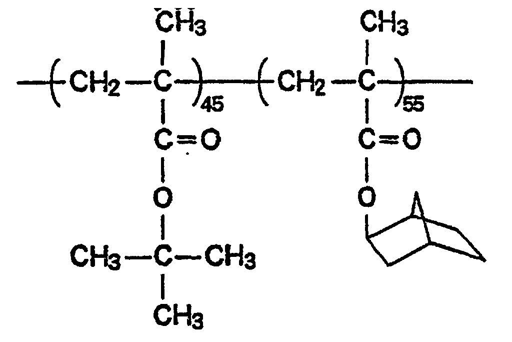 and having a 45:55 composition ratio was prepared. Triphenylsulfonium hexafluoroantimonate as an acid generating substance was added to the solution by 2 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

A solution of 5 wt% of polydiene resin in 1-decene expressed by the following structural formula 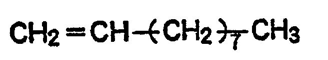 was applied onto the wafer by spin coating, and the resist film was resolved.

### [Control 14]

A 15 wt% cyclohexanone solution of t-butyl methacrylate - norbornyl methacrylate - hydroxyethyl methacrylate terpolymer expressed by the following structural formula 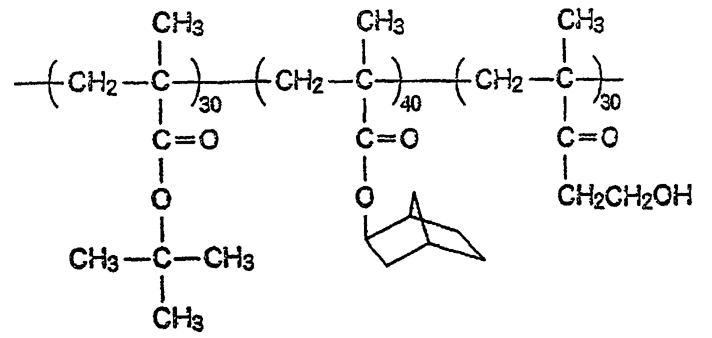 and having a 30:40:30 composition ratio was prepared. Triphenylsulfonium hexafluoroantimonate as an acid generating substance was added to the solution by 5 wt% to the copolymer, and a resist solution was prepared.

This resist solution was applied to an HMDS treated Si wafer by spin coating, and the wafer was prebaked for 100 seconds on a hot plate at 100°C, and a 0.7 µm-thickness resist film was formed.

The thus-coated resist film on the wafer was exposed by a KrF excimer stepper without application of a protecting film and was subjected to PEB at 150°C for 60 seconds.

Then the wafer was immersed for 60 seconds in a 2.38 % TMAH aqueous solution for development.

An unsolved layer was generated on the surface of the resist, and no pattern could be resolved.

## Claims

1. A radiation sensitive material comprising: a copolymer expressed by a general formula 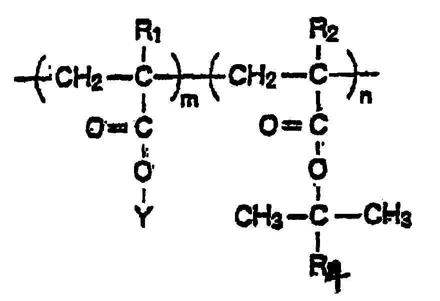 (where Y represents an alicyclic group; R₁ and R₂ represent CH₃ or H, and at least one of R₁ and R₂ is H; and R₄ represents an alkyl group); and a substance generating an acid by application of radiation.

2. A radiation sensitive material according to claim 1, wherein the copolymer includes, by 40-70 mol%, a unit structure including alicyclic groups.

3. A radiation sensitive material comprising:
a terpolymer expressed by a general formula 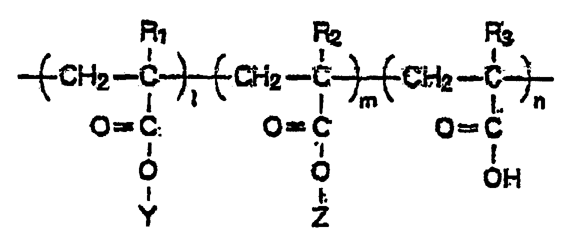 (where Y represents an alicyclic group,
Z represents -C(CH₃)₂R₄, 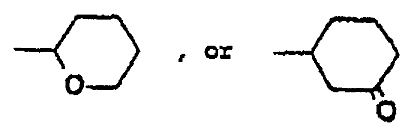 R₁,R₂ and R₃ represent CH₃ or H; and R₄ represents an alkyl group); and
a substance generating an acid by application of radiation.

4. A radiation sensitive material according to claim 3, wherein the terpolymer includes a unit structure containing carboxyl by above 5 mol% and below 35 mol%.

5. A radiation sensitive material comprising:
a terpolymer expressed by a general formula 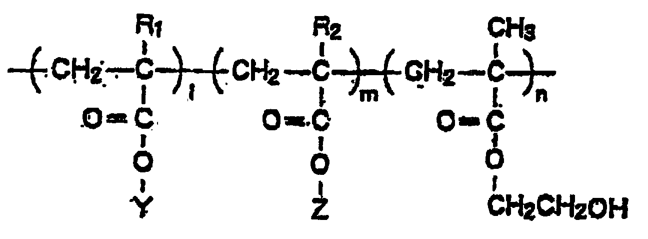 (where Y represents an alicyclic group; and
Z represents -C(CH₃)₂R₄, 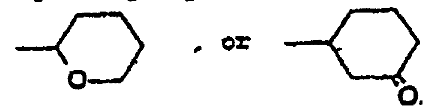
R₁ and R₂ represent CH₃ or H; and R₄ represents an alkyl group); and
a substance generating an acid by application of radiation.

6. A radiation sensitive material according to claim 5, wherein the terpolymer includes a unit structure containing hydroxyethyl methacrylate by above 5 mol%.

7. A radiation sensitive material comprising:
a copolymer expressed by a general formula 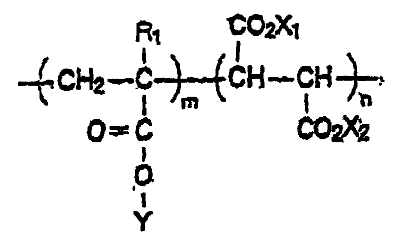 (where X₁ and X₂ represent -C(CH₃)₂R₄, 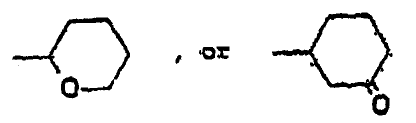 Y represents an alicyclic group, R₁ represents CH₃ or H; and R₄ represents an alkyl group), and
a substance generating an acid by application of radiation.

8. A radiation sensitive material comprising:
a copolymer expressed by a general formula 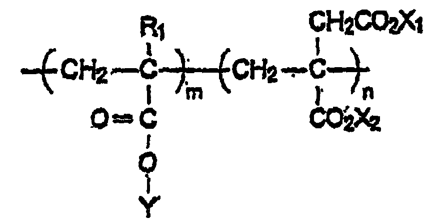 (where X₁ and X₂ represent -C(CH₃)₂R₄, 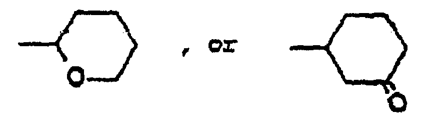 Y represents an alicyclic group; R₁ represents CH₃ or H; and R₄ represents an alkyl group); and
a substance generating an acid by application of radiation.

9. A radiation sensitive material comprising:
a copolymer including:
a unit structure expressed by the general formula 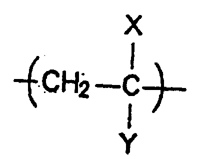 (where at least one of X and Y is a nitrile group); and
a unit structure which generates an alkali soluble group in the presence of an acid; and
a substance generating an acid by application of radiation,
wherein the copolymer includes an alicyclic group.

10. A radiation sensitive material according to claim 9, wherein the copolymer includes t-butyl groups.

11. A radiation sensitive material according to claim 9 or 10, wherein the unit structure 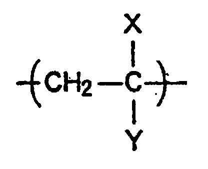 (where at least one of X and Y is a nitrile group) is an acrylonitrile or methacrylonitrile group.

12. A radiation sensitive material according to claim 11, wherein the copolymer includes the acrylonitrile or methacrylonitrile group by 10-70 mol%.

13. A method for forming a pattern comprising the steps of:
preparing a resist of a radiation sensitive material according to any preceding claim;
applying the resist to a substrate to be processed;
prebaking the substrate and then selectively exposing the resist on the substrate to radiation to generate said acid; and
postbaking the substrate, and then developing the resist on the substrate to form the pattern.

14. A method for forming a pattern according to claim 13, wherein developing the resist on the substrate is effected by a developer which is mixed liquid of an organic alkaline aqueous solution and isopropyl alcohol.

15. A method for forming a pattern according to claim 14, wherein the developer contains the isopropyl alcohol by 5 - 95 vol%.

## Patentansprüche

1. Strahlungsempfindliches Material, welches umfasst:
ein Copolymer, das durch eine allgemeine Formel 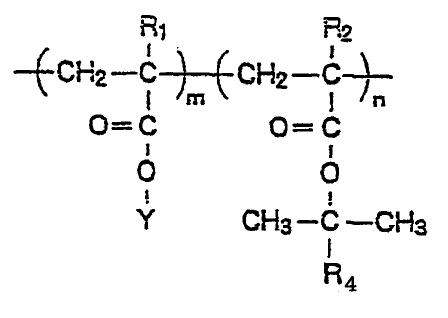 ausgedrückt wird (worin Y eine alicyclische Gruppe repräsentiert; R₁ und R₂ CH₃ oder H repräsentieren, und zumindest eines von R₁ und R₂ H ist; und R₄ eine Alkyl-Gruppe repräsentiert) ; und
eine Substanz, die durch das Aufbringen von Strahlung eine Säure generiert.

2. Strahlungsempfindliches Material nach Anspruch 1, bei welchem das Copolymer zu 40 bis 70 Mol-% eine Struktureinheit einschließt, die alicyclische Gruppen einschließt.

3. Strahlungsempfindliches Material, welches umfasst:
ein Terpolymer, das durch eine allgemeine Formel 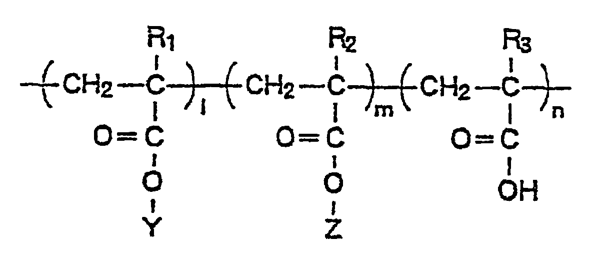 ausgedrückt wird (worin Y eine alicyclische Gruppe repräsentiert; Z -C(CH₃)₂R₄, 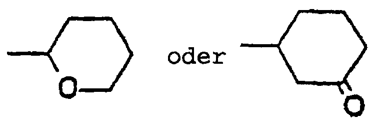 repräsentiert; R₁, R₂ und R₃ CH₃ oder H repräsentieren; und R₄ eine Alkyl-Gruppe repräsentiert); und
eine Substanz, die durch das Aufbringen von Strahlung eine Säure generiert.

4. Strahlungsempfindliches Material nach Anspruch 3, bei welcher das Terpolymer eine Struktureinheit einschließt, die Carboxyl zu über 5 Mol-% und unter 35 Mol-% einschließt.

5. Strahlungsempfindliches Material, welches umfasst:
ein Terpolymer, das durch eine allgemeine Formel 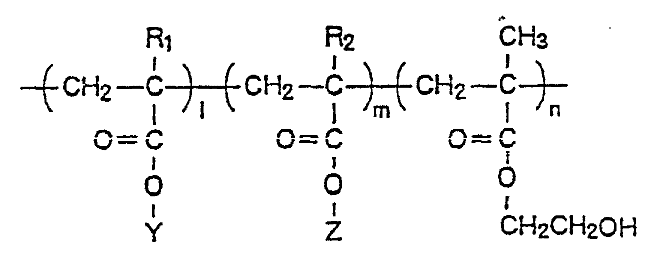 ausgedrückt wird (worin Y eine alicyclische Gruppe repräsentiert; und Z -C(CH₃)₂R₄, 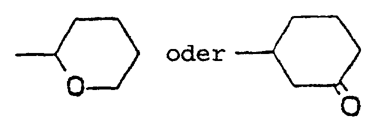 repräsentiert; R₁ und R₂ CH₃ oder H repräsentieren; und R₄ eine Alkyl-Gruppe repräsentiert); und
eine Substanz, die durch das Aufbringen von Strahlung eine Säure generiert.

6. Strahlungsempfindliches Material nach Anspruch 5, bei welcher das Terpolymer eine Struktureinheit einschließt, die Hydroxyethylmethacrylat zu über 5 Mol-% einschließt.

7. Strahlungsempfindliches Material, welches umfasst:
ein Copolymer, das durch eine allgemeine Formel 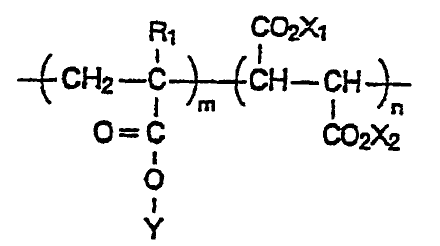 ausgedrückt wird (worin X₁ und X₂ -C(CH₃)₂R₄, 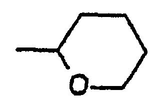 oder 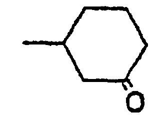 repräsentieren; Y eine alicyclische Gruppe repräsentiert; R₁ CH₃ oder H repräsentiert; und R₄ eine Alkyl-Gruppe repräsentiert); und
eine Substanz, die durch das Aufbringen von Strahlung eine Säure generiert.

8. Strahlungsempfindliches Material, welches umfasst:
ein Copolymer, das durch eine allgemeine Formel 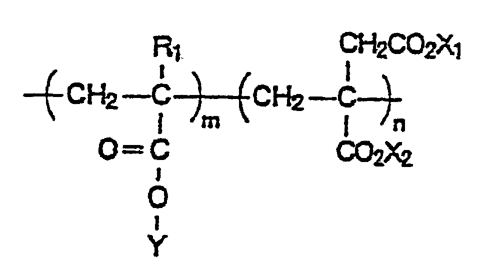 ausgedrückt wird (worin X₁ und X₂ -C(CH₃)₂R₄, 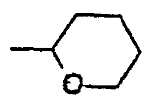 oder 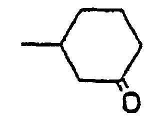 repräsentieren; Y eine alicyclische Gruppe repräsentiert; R₁ CH₃ oder H repräsentiert; und R₄ eine Alkyl-Gruppe repräsentiert); und
eine Substanz, die durch das Aufbringen von Strahlung eine Säure generiert.

9. Strahlungsempfindliches Material, welches umfasst:
ein Copolymer, das einschließt:
eine Struktureinheit, die durch die allgemeine Formel 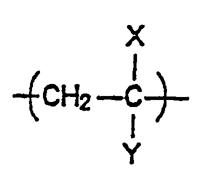 ausgedrückt wird (worin zumindest eines von X und Y eine Nitril-Gruppe ist); und
eine Struktureinheit, die eine Alkali-lösliche Gruppe in Anwesenheit einer Säure generiert; und
eine Substanz, die durch das Aufbringen von Strahlung eine Säure generiert,
wobei das Copolymer eine alicyclische Gruppe einschließt.

10. Strahlungsempfindliches Material nach Anspruch 9, bei welchem das Copolymer tert.Butyl-Gruppen einschließt.

11. Strahlungsempfindliches Material nach Anspruch 9 oder 10, bei welchem die Struktureinheit 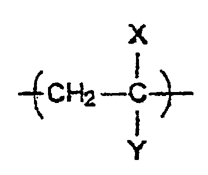 (worin zumindest eines von X und Y eine Nitril-Gruppe ist) eine Acrylnitril- oder Methacrylnitril-Gruppe ist.

12. Strahlungsempfindliches Material nach Anspruch 11, bei welchem das Copolymer die Acrylnitril- oder Methacrylnitril-Gruppe zu 10 bis 70 Mol-% einschließt.

13. Verfahren zur Bildung eines Musters, welches die Schritte umfasst:
Herstellen eines Resists aus einem strahlungsempfindlichen Material nach einem der vorhergehenden Ansprüche;
Aufbringen des Resists auf einem zu verarbeitenden Substrat;
Vorbacken des Substrats und dann selektives Belichten des Resists auf dem Substrat mit Strahlung, um die genannte Säure zu generieren; und
Nachbacken des Substrats, und dann Entwickeln des Resists auf dem Substrat, um das Muster zu bilden.

14. Verfahren zur Bildung eines Musters nach Anspruch 13, bei welchem das Entwickeln des Resists auf dem Substrat mit einem Entwickler bewirkt wird, der eine gemischte Flüssigkeit aus einer organischen alkalischen wässerigen Lösung und Isopropylalkohol ist.

15. Verfahren zur Bildung eines Musters nach Anspruch 14, bei welchem der Entwickler den Isopropylalkohol zu 5 bis 95 Vol.-% enthält.

## Revendications

1. Matériau sensible au rayonnement comprenant: un copolymère exprimé par la formule générale 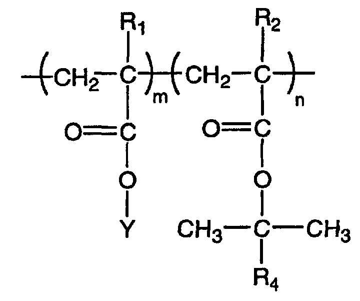 (dans laquelle Y représente un groupe alicyclique ; R₁ et R₂ représentent CH₃ ou H, et au moins un de R₁ et R₂ est H ; et R₄ représente un groupe alkyle); et une substance formant un acide par application du rayonnement.

2. Matériau sensible au rayonnement selon la revendication 1, dans lequel le copolymère comprend 40 - 70% en moles, d'une structure unitaire comprenant des groupes alicycliques.

3. Matériau sensible au rayonnement comprenant: un terpolymère exprimé par la formule générale 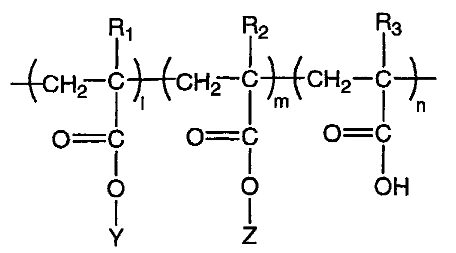 (dans laquelle Y représente un groupe alicyclique ; Z représente
- C(CH₃)₂R₄, 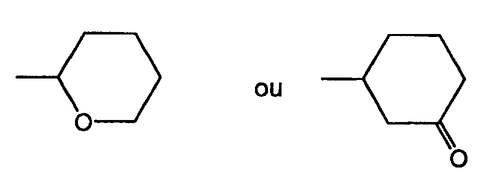 R₁, R₂ et R₃ représentent CH₃ ou H ; et R₄ représente un groupe alkyle) ; et une substance formant un acide par application du rayonnement.

4. Matériau sensible au rayonnement selon la revendication 3, dans lequel le terpolymère comprend une structure unitaire contenant plus de 5% en moles et moins de 35% en moles d'un groupe carboxyle.

5. Matériau sensible au rayonnement comprenant: un terpolymère exprimé par la formule générale 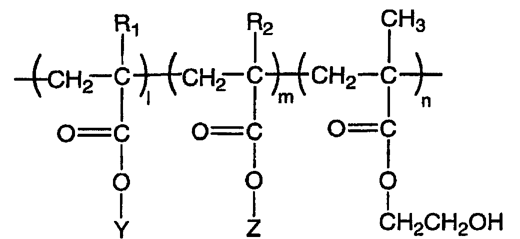 (dans laquelle Y représente un groupe alicyclique ; et Z représente -C(CH₃)₂R₄, 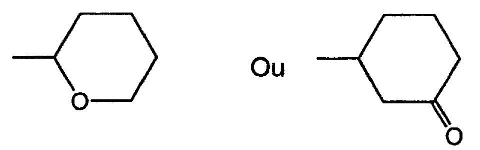 R₁ et R₂ représentent CH₃ ou H ; et R₄ représente un groupe alkyle) ; et une substance formant un acide par application du rayonnement.

6. Matériau sensible au rayonnement selon la revendication 5, dans lequel le terpolymère comprend une structure unitaire contenant plus de 5% en moles de méthacrylate d'hydroxyéthyle.

7. Matériau sensible au rayonnement comprenant: un copolymère exprimé par la formule générale 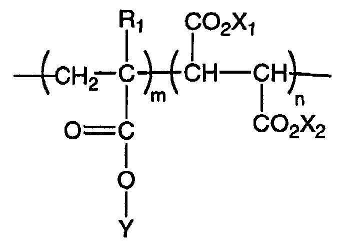 (dans laquelle X₁ et X₂ représentent
-C(CH₃)₂R₄, 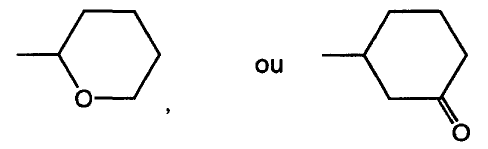
Y représente un groupe alicyclique; R₁ représente CH₃ ou H ; et R₄ représente un groupe alkyle) ; et une substance formant un acide par application du rayonnement.

8. Matériau sensible au rayonnement comprenant: un copolymère exprimé par la formule générale 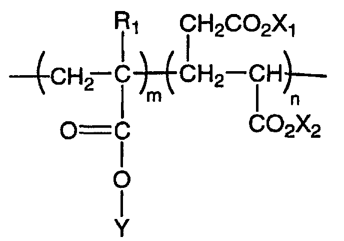 (dans laquelle X₁ et X₂ représentent
-C(CH₃)₂R₄, 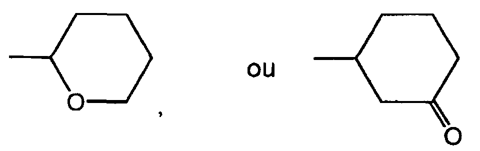
Y représente un groupe alicyclique ; R₁ représente CH₃ ou H ; et R₄ représente un groupe alkyle) ; et une substance formant un acide par application du rayonnement.

9. Matériau sensible au rayonnement comprenant: un copolymère comprenant une unité structurelle exprimée par la formule générale 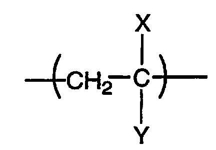 (dans laquelle au moins un de X et Y est un groupe nitrile) ; et une unité structurelle qui forme un groupe alcalin soluble en présence d'un acide ; et une substance formant un acide par application du rayonnement, dans lequel le copolymère comprend un groupe alicyclique.

10. Matériau sensible au rayonnement selon la revendication 9, dans lequel le copolymère comprend des groupes t-butyle.

11. Matériau sensible au rayonnement selon la revendication 9 ou 10, dans lequel l'unité structurelle 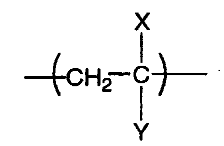 (dans laquelle au moins un de X et Y est un groupe nitrile) est un groupe acrylonitrile ou méthacrylonitrile.

12. Matériau sensible au rayonnement selon la revendication 11, dans lequel le copolymère comprend10 - 70% en moles de groupe acrylonitrile ou méthacrylonitrile.

13. Procédé de formation d'un motif comprenant les étapes consistant à :
préparer une réserve d'un matériau sensible au rayonnement selon l'une quelconque des revendications précédentes ;
appliquer la réserve à un substrat devant être traité ;
pré-cuire le substrat et ensuite exposer sélectivement la réserve sur un substrat à un rayonnement pour former ledit acide ; et
cuire postérieurement le substrat, et ensuite développer la réserve sur un substrat pour former le motif.

14. Procédé de formation d'un motif selon la revendication 13, dans lequel la réserve sur le substrat est effectuée par un développeur qui est un liquide mixte d'une solution aqueuse alcaline organique et de l'alcool isopropylique.

15. Procédé de formation d'un motif selon la revendication 14, dans lequel le développeur contient 5 - 95% en volume d'alcool isopropylique.
